# EUROPÄISCHE PATENTSCHRIFT

(11) **EP 2 520 018 B1**
(45) Veröffentlichungstag und Bekanntmachung des Hinweises auf die Patenterteilung: **06.08.2014**
(21) Anmeldenummer: 10798726.5
(22) Anmeldetag: 01.12.2010
(51) Int. Cl.: H03F 1/52

(54) **SCHALTUNGSANORDNUNG ZUR REDUNDANTEN STROMVERSORGUNG EINES LEISTUNGSVERSTÄRKERS**
CIRCUIT ARRANGEMENT FOR THE REDUNDANT CURRENT SUPPLY OF A POWER AMPLIFIER
CIRCUITERIE POUR L'ALIMENTATION ÉLECTRIQUE REDONDANTE D'UN AMPLIFICATEUR DE PUISSANCE

(30) Priorität: 30.03.2010 DE 102010013331; 28.12.2009 DE 102009060671
(43) Veröffentlichungstag der Anmeldung: 07.11.2012
(73) Patentinhaber: Rohde & Schwarz GmbH & Co. KG, 81671 München (DE)
(72) Erfinder: KAEHS, Bernhard, 82008 Unterhaching (DE); MOLL, Ludwig, 82399 Raisting (DE)
(74) Vertreter: Körfer, Thomas
(86) Internationale Anmeldenummer: PCT/EP2010/007306
(87) Internationale Veröffentlichungsnummer: WO 2011/079901

(56) Entgegenhaltungen:
- EP-A1- 1 835 711
- EP-A2- 1 750 366
- WO-A1-2005/046198
- JP-A- 2005 057 377
- US-A- 5 561 397
- US-A- 6 064 260

## Beschreibung

Die Erfindung betrifft eine Schaltungsanordnung zur redundanten Stromversorgung für einen Leistungsverstärker, insbesondere für einen Hochfrequenzleistungsverstärker, wie er in der Nachrichtentechnik zur Aussendung von Rundfunk- und Fernsehsignalen, bei Mobilfunk-Basisstationen, bei der Radartechnik, bei der EMV-Messtechnik und für wissenschaftliche Zwecke zur Erzeugung hoher Hochfrequenzleistungen eingesetzt wird.

Hochfrequenzleistungsverstärker werden typischerweise aus mehreren einzelnen Hochfrequenz-Endstufenverstärkern, die über Koppler (Leistungsteiler und Leistungskoppler) zu Hochfrequenz-Endstufenteilen zusammengeschaltet werden, gebildet. Erst dadurch wird die benötigte Summenausgangsleistung erreicht. Bei Ausfall einer oder mehrerer dieser Hochfrequenz-Endstufenverstärkern kommt es zwar zu einer reduzierten Ausgangsleistung, jedoch ist auch mit einer reduzierten Ausgangsleistung weiterhin ein Sendebetrieb - mit verringertem Signal-Rauschabstand S/N am Empfangsort - möglich. Die verbleibende Ausgangsleistung errechnet sich nach der Formel Pₐᵤₛ = Pₙₒₘ*m²/n², wobei Pₐᵤₛ hierbei die verbleibende Ausgangsleistung darstellt, Pₙₒₘ die nominelle Ausgangsleistung bedeutet, wenn alle Endstufenverstärker funktionieren, [m] die Anzahl der funktionierenden Endstufenverstärker ist und [n] die Gesamtanzahl der Endstufenverstärker darstellt.

Dagegen ist bei Ausfall eines Netzteils kein Sendebetrieb mehr möglich, sofern dieses nicht redundant ausgeführt ist. Dabei unterliegen gerade die Netzteile einem relativ hohen Ausfallrisiko, stellen sie doch das Bindeglied zwischen dem öffentlichen Stromversorgungsnetz und den Baugruppen in den einzelnen Geräten dar. Die Qualität des öffentlichen Netzes ist nicht nur in verschiedenen Ländern, sondern auch innerhalb von Industrieanlagen sehr unterschiedlich, so dass hohe Spannungsschwankungen, Spannungsspitzen oder kurze Unterbrechungen keine Seltenheit darstellen. Zusätzlich führen immer höher taktende und leistungsstärkere Baugruppen und gleichzeitig der Wunsch nach kompakteren Netzteilen zu komplexen Schaltnetzteilen, die zahlreiche, hoch belastete, Bauteile aufweisen und damit statistischen Ausfällen unterliegen. Zur Erhöhung der Betriebszuverlässigkeit ist daher eine redundante Stromversorgung des Leistungsverstärkers wünschenswert.

Aus der US 6,064,260 ist eine redundante Anordnung von Netzteilen zur Stromversorgung mehrerer voneinander unabhängiger Hochfrequenzleistüngsverstärker bekannt. Jeder Hochfrequenzleistungsverstärker weist ein Netzteil, eine Hochfrequenzleistungsstufe und einen Linearisierer auf, wobei die Hochfrequenzleistungsstufe und der Linearisierer die Last des Netzteils darstellen und durch dieses mit Energie versorgt werden. Gleichzeitig werden alle Netzteile zusätzlich mit einem Versorgungsbus verbunden. Bei Ausfall eines Netzteils erzeugt dieses ein Fehlersignal, wodurch ein Schalter geöffnet wird und das Netzteil von der Last des Hochfrequenzleistungsverstärkers und des Versorgungsbus getrennt wird. Die restlichen Netzteile sind so dimensioniert, dass diese den Hochfrequenzleistungsverstärker weiterhin mit Energie versorgen können in dem das Netzteil ausgefallen ist. Ein Stromsensor erfasst zudem die Stromaufnahme der angeschlossenen Last. Liegt der aufgenommene Strom nicht innerhalb eines definierten Bereichs, so lässt dies auf einen Fehler in der Hochfrequenzleistungsstufe oder dem Linearisierer schließen. Ein Schalter trennt im Folgenden die Last vom Netzteil des Leistungsverstärkers und dem Versorgungsbus.

Nachteilig an der Anordnung der US 6,064,260 ist, dass es nicht möglich ist einzelne Endstufenverstärker, die zusammen einen Hochfrequenzleistungsverstärker bilden, abzuschalten. Der Hochfrequenzverstärker muss als Ganzes weiterbetrieben oder abgeschaltet werden, wobei dieser im letzteren Fall kein Signal mehr aussendet. Ein Betrieb mit einer reduzierten Ausgangsleistung ist dabei nicht vorgesehen. Um eine Redundanz sicherzustellen, müssen alle Netzteile deutlich überdimensioniert sein. Sind z.B. einzig zwei Hochfrequenzleistungsverstärker mit je einem Netzteil mit dem Versorgungsbus verbunden, so muss jedes Netzteil für die doppelte Leistung ausgelegt sein, um im Fehlerfall den anderen Leistungsverstärker mit Energie versorgen zu können. Ansonsten würden ein oder beide Stromsensoren der Hochfrequenzverstärker einen Fehler melden, was dazu führen würde, dass ein oder beide Hochfrequenzverstärker über die entsprechenden Schalter vom Versorgungsbus getrennt werden. Zumindest ein Hochfrequenzverstärker würde aber seinen Betrieb gänzlich einstellen. Um eine Redundanz zu erreichen, verteuert sich gerade bei Netzteilen mit Leistungen von mehreren Kilowatt die gesamte Anordnung signifikant. Sind z.B. mehr als zwei Hochfrequenzleistungsverstärker an den Versorgungsbus angeschlossen, lässt sich zwar die Leistungsreserve der Netzteile zu einem gewissen Teil verringern, jedoch müssen für die Versorgung von identischen Verstärkerstufen in Abhängigkeit der Anzahl der einzelnen Leistungsverstärker jeweils unterschiedliche Netzteile eingesetzt werden. Die unterschiedliche Größe der Netzteile macht eine einheitliche Gehäusekonstruktion für eine unterschiedliche Anzahl an Leistungsverstärkern innerhalb eines Gehäuses unmöglich. Weiterhin müssen die verwendeten Schalter im Fehlerfall einen Kurzschlussstrom von z.T. mehr als 100 A abschalten können. Die Größe, sowie die Kosten für einen solchen Schalter sind daher nicht vernachlässigbar.

Der Erfindung liegt daher die Aufgabe zugrunde eine Schaltungsanordnung zur redundanten Netzteil-Stromversorgung für einen Hochfrequenzleistungsverstärker zu schaffen, bei welcher die einzelnen Netzteile eine relativ geringe Leistungsreserve haben und bei einem Ausfall von zumindest einem Netzteil ein weiterer Betrieb, wenn auch mit verminderter Sendeleistung, weiterhin möglich ist. Die verwendeten Netzteile sollen dabei einheitlich sein, um in der Beschaffung und der Gehäusekonstruktion günstige Rahmenbedingungen zu erzeugen.

Die Aufgabe wird durch eine Schaltungsanordnung mit den Merkmalen des Anspruchs 1 gelöst. Die Unteransprüche enthalten vorteilhafte Weiterbildungen der Erfindung.

Die erfindungsgemäße Schaltungsanordnung sorgt für eine redundante Stromversorgung eines Leistungsverstärkers, insbesondere eines Hochfrequenzleistungsverstärkers, wobei der Leistungsverstärker mehrere Endstufenteile und mehrere Netzteile aufweist. Die Netzteile sind dabei an ihren lastseitigen Anschlüssen zusammengeschaltet und versorgen die Endstufenteile gemeinsam mit Energie. Fällt zumindest ein Netzteil aus, so wird zumindest ein Endstufenteil unmittelbar aktiv abgeschaltet.

Dadurch, dass verschiedene Endstufenteile eines Leistungsverstärkers über eine gemeinsame Zuleitung von verschiedenen Netzteilen versorgt werden, erfolgt auch bei Ausfall eines Netzteils ein weiterer Betrieb, ohne dass hierfür die verbleibenden Netzteile die Versorgung zwangsweise übernehmen müssen. Einhergehend mit dem Ausfall eines Netzteils wird eine bestimmte Anzahl an Endstufenteilen abgeschaltet, wobei ein weiterer Betrieb, wenn auch mit verminderter Sendeleistung, weiterhin möglich ist. Die Leistung der Netzteile kann daher an den normalen Betriebsablauf angepasst werden, ohne Einbußen in der Redundanz hinnehmen zu müssen. Die Netzteile verfügen ferner alle bevorzugt über die gleiche Bauform, was eine Integration in das Gehäuse erleichtert.

Ein weiterer Vorteil der Erfindung ist dass alle Netzteile an ihrem lastseitigen gemeinsamen Verbindungspunkt an zumindest ein gemeinsames Filter angeschlossen sind. Gerade bei hohen Leistungen von z.B. mehreren Kilowatt ist ein gemeinsam nutzbares Filter, welches die Netzteile von einer Beeinflussung der Hochfrequenzenergie der Endstufenteile schützt, deutlich günstiger, als wenn für jedes Netzteil ein separates Filter verwendet wird. Der notwendige Platzbedarf für ein solch gemeinsam genutztes Filter ist ebenfalls deutlich niedriger, im Vergleich zu mehreren Einzelfiltern.

Weiterhin von Vorteil ist, dass neben den Endstufenteilen des Leistungsverstärkers auch Funktionseinheiten innerhalb des Leistungsverstärkers, wie z.B. der Vorverstärker, der Treiberverstärker, die Steuerung, die Leistungsregelung inklusive Hochfrequenzdetektor, die Fehlerüberwachung und mehrere Lüfter ebenfalls von allen Netzteilen über eine Leitung gemeinsam versorgt werden. Dadurch können neben den Endstufenteilen auch die verschiedenen zentralen Komponenten redundant mit Energie versorgt werden, ohne dass dabei zusätzliche Kosten in Form weiterer Netzteile entstehen.

Ein Vorteil einer Ausführungsform der erfindungsgemäßen Schaltungsanordnung zur redundanten Stromversorgung ist, dass jedes Netzteil bei einem Ausfall über eine Statusleitung ein Fehlersignal ausgibt; welches dazu benutzt wird, eine bestimmte Anzahl an Endstufenteilen abzuschalten. Dies gelingt über ein Schaltelement, welches die Vorspannung der Leistungstransistoren des betroffenen Endstufenteils z.B. gegen Masse schaltet. Dabei wird, um Intermodulationsprodukte zu vermeiden, die Hochfrequenz-Steuerleistung über eine Schalteinheit von dem Endstufenteil abgekoppelt. Hierzu werden immer die Endstufenteile paarweise abgeschaltet, die gemeinsam von einem 90°-Hybridkoppler angesteuert werden, um dadurch die auftretenden Reflektionen in den Lastausgleichswiderstand leiten zu können. Dadurch ist sichergestellt, dass für die restlichen, im Betrieb befindlichen Endstufenteile exakt gleiche Betriebsbedingungen bezüglich des Pegels oder des Frequenzgangs vorherrschen. Das Schaltelement muss dabei nur einen sehr kleinen Signalstrom schalten, so dass dieses aus SMD-Bauteilen (surface-mounted device; oberflächenmontierbares Bauelement) aufgebaut sein kann.

In einer weiteren erfindungsgemäßen Ausführungsform mit zwei oder mehr Netzteilen, werden die Statusleitungen mit offenen Kollektorausgängen aller Netzteile unmittelbar miteinander und mit einer bestimmten Anzahl an Schaltelementen und/oder Schalteinheiten von den Endstufenteilen verbunden. Die Verbindung der Statusleitungen miteinander wirkt sich wie eine Oder-Verknüpfung aus. Dadurch wird ohne eine zusätzliche Steuereinheit sichergestellt, dass bei Ausfall eines Netzteils die notwendige Anzahl an Endstufenteilen abgeschaltet wird und ein Betrieb, wenn auch mit verminderter Ausgangsleistung, durch die verbleibenden Netzteile aufrecht erhalten werden kann.

In einem weiteren erfindungsgemäßen Ausführungsbeispiel der vorliegenden Erfindung wird die Statuseinheit eines jeden Netzteils einzeln mit einer Logikeinheit verbunden. Die Ausgänge der Logikeinheit sind dabei mit verschiedenen Schaltelementen und Schalteinheiten von verschiedenen Endstufenteilen verbunden. Die Logikeinheit entscheidet, wie viele und welche Endstufenteile bei einem Ausfall von einem oder mehreren Netzteilen abgeschaltet werden. Dadurch kann mit einer minimalen Anzahl von Schaltelementen und Schalteinheiten eine ausreichend hohe Redundanz erreicht werden.

Verschiedene Ausführungsbeispiele der Erfindung werden nachfolgend unter Bezugnahme auf die Zeichnung beispielhaft beschrieben. Gleiche Gegenstände weisen dieselben Bezugszeichen auf. Die entsprechenden Figuren der Zeichnung zeigen im Einzelnen:
- Fig. 1: einen Schaltplan eines ersten Ausführungsbeispiels der erfindungsgemäßen Schaltungsanordnung zur redundanten Stromversorgung für einen Leistungsverstärker;
- Fig. 2: einen Schaltplan eines zweiten Ausführungsbeispiels für eine erfindungsgemäße Schaltungsanordnung zur redundanten Stromversorgung für einen Leistungsverstärker;
- Fig. 3: einen Schaltplan eines dritten Ausführungsbeispiels für eine erfindungsgemäße Schaltungsanordnung zur redundanten Stromversorgung für einen Leistungsverstärker;
- Fig. 4: einen Schaltplan eines vierten Ausführungsbeispiels für eine erfindungsgemäße Schaltungsanordnung zur redundanten Stromversorgung für einen Leistungsverstärker;
- Fig. 5: den beispielhaften Anschluss einer erfindungsgemäßen Schalteinheit an einen 90°-Hybridkoppler;
- Fig. 6: den Aufbau eines Ausführungsbeispiels des Schaltelements für die erfindungsgemäße Schaltungsanordnung zur redundanten Stromversorgung für einen Leistungsverstärker;
- Fig. 7: den erfindungsgemäßen Aufbau und Anschluss einer Schalteinheit gemäß einem Ausführungsbeispiel.

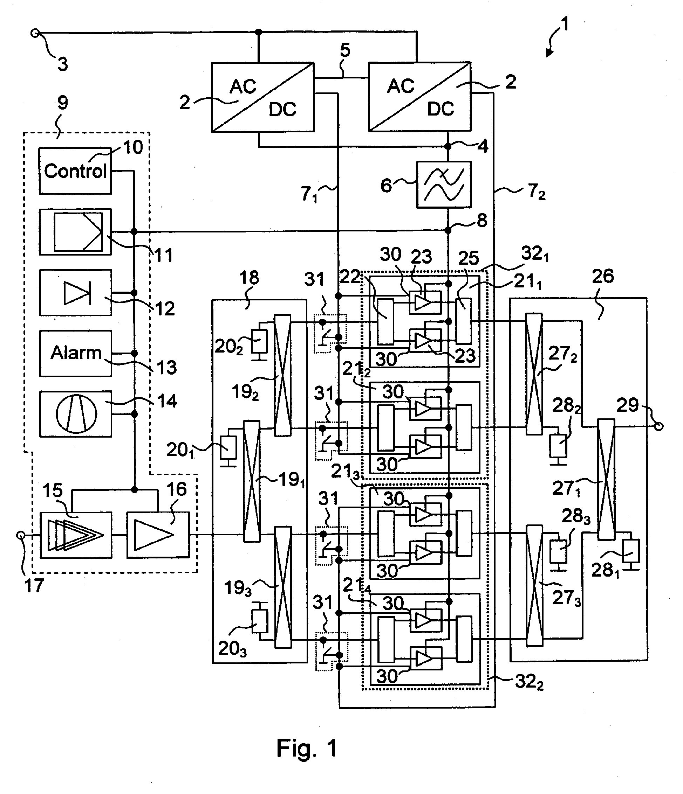

Fig. 1 zeigt einen Schaltplan der erfindungsgemäßen Schaltungsanordnung zur redundanten Stromversorgung für einen Leistungsverstärker 1. Der Leistungsverstärker 1 weist zwei Netzteile 2 auf, die eingangsseitig über einen Anschluss 3 Energie, vorzugsweise aus dem öffentlichen Netz, beziehen. Die lastseitigen Ausgänge der beiden Netzteile 2 werden am Knoten 4 miteinander verbunden. Beide Netzteile 2 sind parallel geschalten. Über eine Leitung 5 synchronisieren sich beide Netzteile 2, so dass eine an den Knoten 4 angeschlossene Last gleichmäßig unter den Netzteilen 2 aufgeteilt wird und jedes Netzteil 2 jeweils die gleiche Leistung bereit stellt.

An den lastseitigen Anschluss der beiden Netzteile 2 wird am Knoten 4 ein gemeinsames Filter 6 angeschlossen. Dieses Filter 6 dient dazu, dass die beiden Netzteile 2 an ihrem lastseitigen Ausgang vor Störungen durch im Verstärker auftretende Hochfrequenzenergie geschützt sind. Das Filter 6 kann als T- oder PI-Filter realisiert sein, wobei dieses Filter für Ströme von z.B. bis zu 150 A ausgelegt ist. Dieses Filter wird durch das Zusammenschalten der beiden Netzteile 2 und der daraus resultierenden gemeinsamen Versorgungsleitung nur einmal benötigt. Dadurch erfolgt eine Platz- und Kosteneinsparung. Beide Netzteile 2 sind weiterhin so beschaffen, dass bei einem Ausfall das betroffene Netzteil 2 an seinem lastseitigen Ausgang keinen Kurzschluss schaltet. Weiterhin verfügen beide Netzteile 2 je über eine Statusleitung 7₁, 7₂, die mit dem Netzteil 2 über einen offenen Kollektorausgang (Open-Collector) verbunden sind. Fällt ein Netzteil 2 aus, so wird die Statusleitung 7₁ oder 7₂ mit Masse verbunden.

Die gemeinsame Versorgungsleitung 8, welche über das Filter 6 mit beiden Netzteilen 2 verbunden ist, versorgt eine Vielzahl von einzelnen Baugruppen innerhalb des Leistungsverstärkers 1. Einige dieser Baugruppen sind zum Betrieb des Leistungsverstärkers 1 notwendig und müssen bei einem Ausfall eines Netzteils 2 zwingend weiter mit Energie versorgt werden, um einen Totalausfall zu vermeiden. Bei diesen Baugruppen handelt es sich um die zentralen Funktionseinheiten 9, die Komponenten wie eine Steuerung 10, eine Leistungsregelung 11 mit HochfrequenzDetektor 12, eine Fehlerüberwachung 13, zumindest einen Lüfter 14, einen Vorverstärker 15 und einen Treiberverstärker 16 umfassen. Alle diese Funktionseinheiten 9 sind an die gemeinsame Versorgungsleitung 8 angeschlossen.

Am Eingang 17 wird dem Vorverstärker 15 des Leistungsverstärkers 1 ein zu verstärkendes Signal von einer nicht dargestellten Signalquelle zugeführt. Der Ausgang des Vorverstärkers 15 ist mit dem Eingang des Treiberverstärkers 16 verbunden. Der Ausgang des Treiberverstärkers 16 ist mit einem Leistungsteiler 18 verbunden. Der Leistungsteiler 18 besteht aus drei Kopplern 19₁, 19₂, 19₃, die bevorzugt als 90°-Hybridkoppler ausgeführt sind, und teilt ein Eingangssignal auf mehrere Ausgangssignale mit kleinerem Pegel herunter. Der erste Koppler 19₁ kann z.B. auch als Wilkinson Koppler ausgeführt sein, bzw. eine beliebige Bauart aufweisen. Der erste Koppler 19₁ ist in diesem Fall allerdings ebenfalls als 90°-Hybridkoppler 19₁ ausgeführt, wobei sein Eingang mit dem Anschluss des Treiberverstärkers 16 verbunden ist. Ein Ausgang des ersten 90°-Hybridkopplers 19₁ ist über einen Lastausgleichswiderstand 20₁ mit Masse verbunden. Der Lastausgleichswiderstand 20 nimmt die Differenzleistung zwischen dem Eingang und den Ausgängen auf. Ein weiterer Ausgang des ersten 90°-Hybridkopplers 19₁ ist mit dem Eingang eines zweiten 90°-Hybridkoppler 19₂ verbunden. Ein dritter Ausgang des ersten 90°-Hybridkopplers 19₁ ist mit dem Eingang eines dritten 90°-Hybridkoppler 19₃ verbunden. Das Signal kommend vom Treiberverstärker 16 weist am Ausgang des ersten 90°-Hybridkoppler 19₁ und am Eingang des zweiten 90°-Hybridkoppler 19₂ eine Phasenverschiebung von -90° auf. Der zweite 90°-Hybridkoppler 19₂ weist an einem Ausgang einen Lastausgleichswiderstand 20₂ auf, welcher mit Masse verbunden ist. Ein weiterer Ausgang des 90°-Hybridkoppler 19₂ ist mit einem Endstufenteil 21₁ verbunden. Das Signal am Eingang des Endstufenteils 21₁ ist gegenüber dem Signal am Ausgang des Treiberverstärkers 16 um -180° verschoben. Ein weiterer Ausgang des 90°-Hybridkoppler 19₂ ist mit dem Endstufenteil 21₂ verbunden. Das Signal am Eingang des Endstufenteils 21₂ ist gegenüber dem Signal am Ausgang des Treiberverstärkers 16 um -90° verschoben.

Der dritte 90°-Hybridkoppler 19₃ weist an einem Ausgang einen Lastausgleichswiderstand 20₃ auf, welcher mit Masse verbunden ist. Ein weiterer Ausgang des 90°-Hybridkoppler 19₃ ist mit einem Endstufenteil 21₃ verbunden. Das Signal am Eingang des Endstufenteils 21₃ ist gegenüber dem Signal am Ausgang des Treiberverstärkers nicht verschoben. Ein weiterer Ausgang des 90°-Hybridkoppler 19₃ ist mit dem Endstufenteil 21₄ verbunden. Das Signal am Eingang des Endstufenteils 21₄ ist gegenüber dem Signal am Ausgang des Treiberverstärkers 16 um -90° verschoben.

Über die drei 90°-Hybridkoppler 19₁, 19₂, 19₃ wird ein Eingangssignal in vier Signale aufgeteilt, die gegenüber dem Eingangssignal phasenverschoben sein können und deren Pegel bei Anpassung jeweils ein Viertel des Pegels des Eingangssignals beträgt. Der erste 90°-Hybridkoppler 19₁ kann auch als Wilkinson Koppler ausgeführt sein. Die Signale an seinem Ausgang müssen dabei keine Phasenverschiebung zueinander aufweisen.

Die verschiedenen Endstufenteile 21₁, 21₂, 21₃, 21₄ sind bevorzugt gleich aufgebaut. Ein Eingangssignal kommend von dem Ausgang eines 90°-Hybridkopplers 19₂, 19₃ wird einem Leistungsteiler 22 zugeführt. Dieser Leistungsteiler teilt das Eingangssignal gleichmäßig auf zwei Signale auf. Diese Signale werden jeweils einem Endstufenverstärker 23 zugeführt. Jeder dieser Endstufenverstärker 23 ist mit der gemeinsamen Versorgungsleitung 8 verbunden. Der Ausgang jeder dieser Endstufenverstärker 23 ist mit einem Leistungskoppler 25 verbunden. Dieser Leistungskoppler 25 führt zwei Signale zu einem Signal mit einer höheren Amplitude zusammen. In diesem Ausführungsbeispiel weist der Leistungsverstärker zumindest zwei Netzteile 2 und zumindest vier Endstufenteile 21 auf, wobei die Netzteile an ihren lastseitigen Anschlüssen zusammengeschaltet sind und die Endstufenteile mit Energie versorgen. Zwei Endstufenteile 21₁, 21₂ und 21₃, 21₄ werden jeweils gemeinsam von je einem 90°-Hybridkoppler 19₂, 19₃ angesteuert und bilden je eine Endstufeneinheit 32₁ und 32₂. Bei Ausfall eines Netzteils 2, werden zwei Endstufenteile 21₁, 21₂ oder 21₃, 21₄, bzw. eine solche Endstufeneinheit 32₁, 32₂ aktiv abgeschaltet.

Unter dem Begriff aktiv abschalten ist im Ausführungsbeispiel zu verstehen, dass sowohl die Vorspannung der Leistungstransistoren des betroffenen Endstufenteils 21 abgeschaltet, als auch die Hochfrequenz-Steuerleistung von dem betroffenen Endstufenteil 21 abgekoppelt wird. Dies erfolgt unmittelbar durch ein Steuersignal auf einer Statusleitung 7, welches von dem betroffenen Netzteil 2 selbst ausgegeben wird. Es ist hierbei keine zusätzliche Einrichtung erforderlich, die z.B. die Ströme auf den Leitungen detektiert und verzögert den Stellbefehl ausgibt. Dieses Steuersignal wird den Schalteinheiten 31 und Schaltelementen 30 des betroffenen Endstufenteils 21 zugeführt. Bei dem Steuersignal kann es sich um ein Fehlersignal handeln, welches z.B. auf den Ausfall des Netzteils 2 schließen lässt. Das Steuersignal selbst kann allerdings auch dann ausgegeben werden, sobald ein als kritisch einzustufender Lastzustand erreicht wird, oder eine Komponente innerhalb des Netzteils 2 außerhalb definierter Parameter arbeitet. Gerade letzterer Betriebszustand ist mit externen Einrichtungen nicht zu erfassen.

Der Ausgang des Leistungskopplers 25 der verschiedenen Endstufenteile 21₁, 21₂, 21₃, 21₄ ist mit einem Leistungskoppler 26 verbunden. Dieser Leistungskoppler 26 besteht im Ausführungsbeispiel aus drei 90°-Hybridkopplern 27₁, 27₂, 27₃, die entgegengesetzt zu den drei 90°-Hybridkopplern 19₁, 19₂, 19₃ von dem Leistungsteiler 18 angeordnet sind. Dadurch werden die einzelnen Eingangssignale, die zueinander Phasenverschoben sind, derart zu einem Ausgangssignal zusammengeschaltet, dass sich die Eingangssignale jeweils addieren und nicht auslöschen. Am Ausgang 29 steht ein Ausgangssignal bereit, dessen Amplitude sich aus der Summe der Amplitude der Signale am Ausgang der einzelnen Endstufenverstärker 23 der einzelnen Endstufenteile 21₁, 21₂, 21₃, 21₄ zusammensetzt.

Hierzu wird das Signal am Ausgang des ersten Endstufenteils 21₁ einem ersten Eingang eines zweiten 90°-Hybridkopplers 27₂ zugeführt. Ein weiteres Signal am Ausgang des zweiten Endstufenteils 21₂ wird einem zweiten Eingang des zweiten 90°-Hybridkopplers 27₂ zugeführt. Ein Ausgang des 90°-Hybridkoppler 27₂ ist an einen Lastausgleichswiderstand 28₂ angeschlossen, welcher mit Masse verbunden ist. Das Signal, welches am zweiten Eingang des zweiten 90°-Hybridkoppler 27₂ anliegt, wird durch den zweiten 90°-Hybridkoppler 27₂ um -90° verschoben und ist dadurch Phasengleich mit dem Signal, welches am ersten Eingang des 90°-Hybridkoppler 27₂ anliegt. An einem weiteren Ausgang des 90°-Hybridkoppler 27₂, welcher mit dem ersten Eingang des 90°-Hybridkoppler 27₁ verbunden ist, liegt eine Summe beider Signale an.

Gleiches gilt für die Signale am dritten 90°-Hybridkoppler 27₃ des Leistungskopplers 26. Ein Signal am Ausgang des dritten Endstufenteils 21₃ wird einem ersten Eingang eines dritten 90°-Hybridkopplers 27₃ zugeführt. Ein weiteres Signal am Ausgang des vierten Endstufenteils 21₄ wird einem zweiten Eingang des dritten 90°-Hybridkopplers 27₃ zugeführt. Ein Ausgang des 90°-Hybridkoppler 27₃ ist an einen Lastausgleichswiderstand 28₃ angeschlossen, welcher mit Masse verbunden ist. Das Signal, welches am ersten Eingang des dritten 90°-Hybridkoppler 27₃ anliegt, wird durch den dritten 90°-Hybridkoppler 27₃ um -90° verschoben und ist dadurch Phasengleich mit dem Signal, welches am ersten Eingang des 90°-Hybridkoppler 27₃ anliegt. An einem weiteren Ausgang des 90°-Hybridkoppler 27₃, welcher mit dem zweiten Eingang des 90°-Hybridkoppler 27₁ verbunden ist, liegt eine Summe beider Signale an.

Ein Ausgang des ersten 90°-Hybridkoppler 27₁ ist an einen Lastausgleichswiderstand 28₁ angeschlossen, welcher mit Masse verbunden ist. Das Signal, welches am zweiten Eingang des ersten 90°-Hybridkoppler 27₁ anliegt, wird durch den ersten 90°-Hybridkoppler 27₁ um -90° verschoben und ist dadurch phasengleich mit dem Signal, welches am ersten Eingang des 90°-Hybridkoppler 27₁ anliegt. An einem weiteren Ausgang des 90°-Hybridkoppler 27₁, welcher mit dem Ausgangsanschluss 29 verbunden ist, liegt eine Summe beider Signale an.

Der Koppler 27₁ muss dabei kein 90°-Hybridkoppler sein. Dieser kann z.B. als Wilkinson Koppler ausgeführt sein. Vorteilhaft ist es allerdings, wenn beide Koppler 19₁ und 27₁ von derselben Bauart sind.

Damit bei einem Ausfall eines Netzteils 2 der Leistungsverstärker 1 weiterhin - wenn auch mit verminderter Ausgangsleistung - betrieben werden kann, müssen so viele Verbrauche weggeschaltet werden, dass die restlichen Verbraucher durch das noch vorhandene Netzteil 2 weiterhin versorgt werden können. Dabei ist zu beachten, dass die zentralen Funktionseinheiten 9 zwingend mit Energie versorgt werden müssen. In diesem Ausführungsbeispiel der erfindungsgemäßen Anordnung kann jedes Netzteil 2 zwei Endstufenteile 21 und die zentralen Funktionseinheiten 9 mit Energie versorgen. Fällt ein Netzteil 2 aus, so wird das Potential der dazugehörigen Statusleitung 7₁ oder 7₂ mittels der offenen Kollektorschaltung auf Masse gezogen.

Die Statusleitung 7₁ des ersten Netzteils 2 ist dabei mit einem in dieser Figur nicht dargestellten Schaltelement 30 innerhalb der Endstufenverstärker 23 der Endstufenteile 21₁ und 21₂ verbunden. Über dieses nicht dargestellte Schaltelement 30 wird die Vorspannung der einzelnen Leistungstransistoren innerhalb der Endstufenverstärker 23 abgeschaltet. Dadurch wird die Leistungsaufnahme der Endstufeneinheit nahezu auf Null reduziert. Allerdings werden die Endstufenverstärker 23 weiterhin über die Leistungsteiler 18, 22 mit einer konstanten Hochfrequenz-Eingangsleistung versorgt. Je nach Verstärkertechnologie können an den Endstufenverstärkern 23 Intermodulationsprodukte entstehen, die über die Leistungskoppler 25, 27 an den Ausgangsanschluss 29 des Leistungsverstärkers 1 gelangen, weil die einzelnen Leistungstransistoren in diesem Fall stark nichtlinear arbeiten.

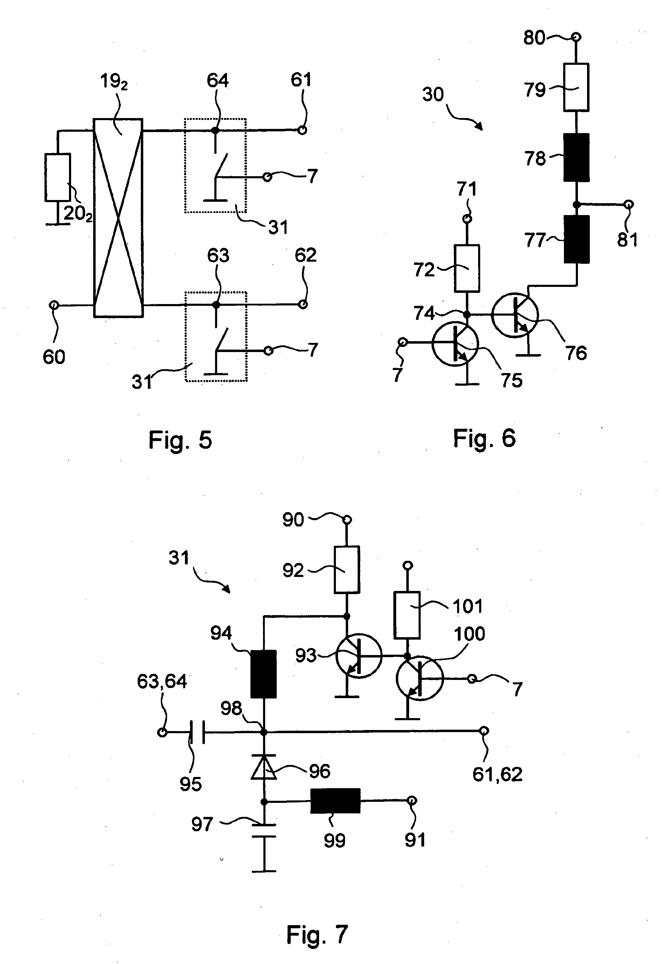

Daher kann es weiterhin erforderlich sein, dass die Hochfrequenz-Eingangsleistung von den bereits aktiv abgeschalteten Endstufenverstärkern 23 abgekoppelt werden muss. Hierfür werden die Leitungen, die die beiden Ausgänge des Leistungsteilers 19₂ mit den Eingängen der Endstufenteile 21₁ und 21₂ verbinden, über die Schalteinheit 31 mit Masse verbunden. Die Schalteinheit 31, welche später noch ausführlich erläutert wird, wird über das Fehlersignal der Statusleitung 7₁ betätigt. Dadurch wird erreicht, dass keine Hochfrequenz-Eingangsleistung mehr an die bereits aktiv abgeschalteten Endstufenverstärker 23 geführt wird, wodurch keinerlei Intermodulationsprodukte am Ausgangsanschluss 29 des Leistungsverstärkers 1 mehr entstehen. Dieses Konzept ist jedoch nur dann sinnvoll möglich, wenn die Leistungsteiler 18 in der 90°-Hybridtechnik aufgebaut sind. Nur in diesem Fall wird zuverlässig vermieden, dass beim Abschalten der Vorspannung der Leistungstransistoren, als auch beim Abkoppeln der Hochfrequenz-Eingangsleistung, keine Fehlanpassung am Eingang des Leistungsteilers 18 auftritt. Die reflektierte Leistung wird dabei im Lastausgleichswiderstand absorbiert. Dadurch wird eine hohe Welligkeit und damit einhergehend das Auftreten von unerwünschten Frequenzgängen vermieden. Die verbleibenden, im Betrieb befindlichen Endstufenteile werden weiterhin mit dem gleichen Eingangssignal unbeeinflusst von den abgeschalteten Endstufenteilen im Arbeitspunkt betrieben. Die Schalteinheit 31 kann auch hinter dem Leistungsteiler 22 angeordnet werden, der im Ausführungsbeispiel ebenfalls als 90°-Hybridkoppler ausgeführt ist und einen Lastausgleichswiderstand aufweisen muss. Eine ausführliche Erklärung findet sich in der Figurenbeschreibung von Fig. 5.

Selbiges gilt für die Endstufenteile 21₃, 21₄. Die Statusleitung 7₂ des zweiten Netzteils 2 ist dabei mit einem in dieser Figur nicht dargestellten Schaltelement 30 innerhalb der Endstufenverstärkers 23 der Endstufenteile 21₃ und 21₄ verbunden. Bei einem Ausfall des zweiten Netzteils wird durch ein Fehlersignal auf der Statusleitung 7₂ über das nicht dargestellte Schaltelement 30 die Vorspannung der einzelnen Leistungstransistoren innerhalb der Endstufenverstärker 23 abgeschaltet.

Um Intermodulationsprodukte zu vermeiden kann das Hochfrequenz-Eingangsleistung von den bereits aktiv abgeschalteten Endstufenverstärkern 23 der Endstufenteile 21₃, 21₄ abgekoppelt werden. Dies geschieht, wie bereits erläutert, dadurch, dass die Leitungen, die die beiden Ausgänge des Leistungsteilers 18 mit den Eingängen der Endstufenteile 21₃ und 21₄ verbinden, über je eine Schalteinheit 31 mit Masse verbunden werden. Diese Schalteinheiten 31 werden durch das Fehlersignal der Statusleitung 7₂ betätigt.

Bei dieser gezeigten Art der Verschaltung wird die Statusleitung 7 eines jeden Netzteils 2 mit einer bestimmten Anzahl von Schaltelementen 30 und Schalteinheiten 31 verbunden. Diese Art der Verschaltung lässt sich allerdings beliebig für n Netzteile 2 fortsetzen. Die Statusleitungen 7 von n Netzteilen 2 sind in diesem Fall mit p Schaltelementen 30 und optional mit q Schalteinheiten 31 verbunden. In diesem Fall ist zu beachten, dass der Leistungsteiler 18 und der Leistungskoppler 26 mehr 90°-Hybridkoppler 20, 27 enthalten muss, als in diesem Ausführungsbeispiel gezeigt.

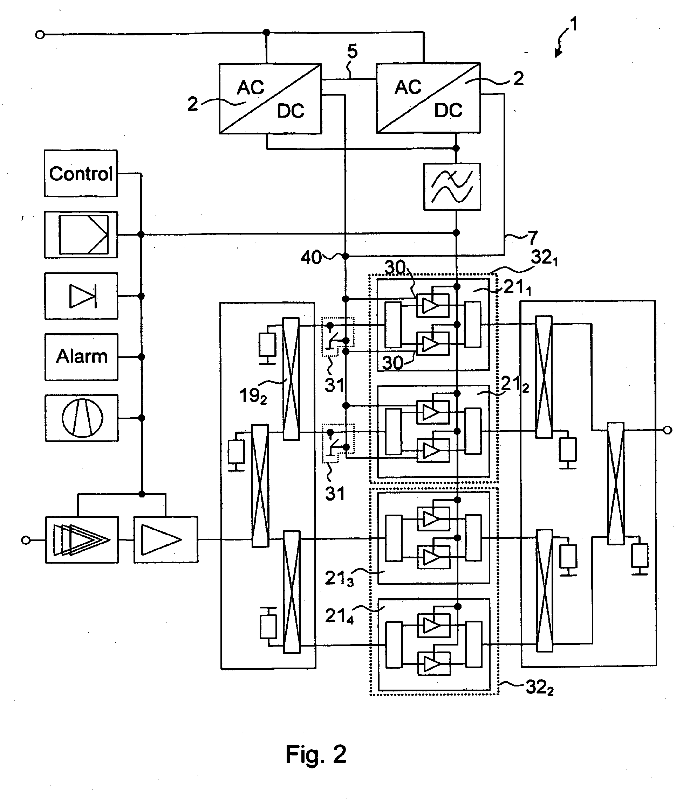

Fig. 2 zeigt einen Schaltplan eines weiteren Ausführungsbeispiels der erfindungsgemäßen Schaltungsanordnung zur redundanten Stromversorgung für einen Leistungsverstärker 1. Je nach Aufbau des Leistungsverstärkers 1 kann es sinnvoll sein, dass ein weiterer Betrieb des Leistungsverstärkers nur bis zu einer festgelegten Ausgangsleistung noch möglich ist. Die verbleibende Ausgangsleistung bei Ausfall eines oder mehrerer Netzteile berechnet sich nach der Formel, welche im einleitenden Teil zu finden ist. In dem Ausführungsbeispiel der Fig. 2 wird der Leistungsverstärker 1 von genau zwei Netzteilen 2 mit Energie versorgt. Bei Ausfall eines Netzteils 2 ist ein weiterer Betrieb des Leistungsverstärkers 1 noch sinnvoll möglich, wohingegen bei einem Ausfall von beiden Netzteilen 2 kein Betrieb mehr möglich ist.

Um die Anzahl der Schaltelemente 30 und Schalteinheiten 31 zu reduzieren und damit die Kosten des Leistungsverstärkers 1 zu senken, wird bei einem Ausfall, egal von welchem Netzteils 2, immer das Endstufenteil 21 abgeschaltet, welches ein Schaltelement 30 und optional eine Schalteinheit 31 aufweist. In diesem Fall wird bei Ausfall egal welchen Netzteils 2 immer die Endstufeneinheit 32₁ aktiv abgeschaltet. Hierfür sind in diesem Fall die Statusleitungen 7 aller Netzteile 2 an einem Knoten 40 miteinander verbunden. Dadurch, dass die Statusleistungen 7 mit je einem Offenen-Kollektor Ausgang der Netzteile 2 verbunden sind, wirkt die gemeinsame Verbindung am Knoten 40 wie eine Oder-Verbindung. Fällt in diesem Ausführungsbeispiel ein Netzteil 2 wegen eines Defekts aus, dann gibt das ausgefallene Netzteil 2 auf der Statusleitung 7 ein gemeinsames Fehlersignal aus, wodurch die Vorspannung der Leistungstransistoren der Endstufenteile 21₁ und 21₂ abgeschaltet wird, die mit den Ausgängen des Leistungsteilers 19₂ verbunden sind. Damit werden die Endstufenteile 21₁, 21₂ nahezu stromlos geschalten. Optional wird noch die Hochfrequenz-Eingangsleistung von den Endstufenteilen 21₁ und 21₂ abgekoppelt, die über eine Schalteinheit 31 verfügen, der das gemeinsame Fehlersignal über die Statusleitung 7 zugeführt wird. Die weiteren Endstufenteile 21₃, 21₄ können indes nicht abgeschaltet werden.

Der Aufbau und die Funktionsweise dieses weiteren erfindungsgemäßen Ausführungsbeispiels der Schaltungsanordnung zur redundanten Stromversorgung für einen Leistungsverstärker 1 entsprechen, mit Ausnahme der gemachten Erläuterungen, dem Ausführungsbeispiel von Fig. 1, worauf hiermit verwiesen wird.

In einem weiteren nicht dargestellten erfindungsgemäßen Ausführungsbeispiel können auch mehr als zwei Netzteile 2 in den Leistungsverstärker 1 aus Fig. 2 integriert werden. Dabei kann die Anzahl der Endstufenteile 21, die der 90°-Hybridkoppler 19, 27 im Leistungsteiler 18 und Leistungskoppler 26, sowie die der Schaltelemente 30 und Schalteinheiten 31 beliebig erhöht werden. Beispielsweise kann der Leistungsverstärker 1 acht Endstufenteile 21 und je sieben 90°-Hybridkoppler 19, 27 im Leistungsteiler 18 und Leistungskoppler 26, die zusammen von vier Netzteilen 2 versorgt werden, umfassen. Dennoch können nur zwei Endstufenteile 21 mit Schaltelementen 30 und Schalteinheiten 31 verbunden sein, weil ein Betrieb bei einem Ausfall von mehr als einem Netzteil 2 in einigen Anwendungen nicht sinnvoll ist.

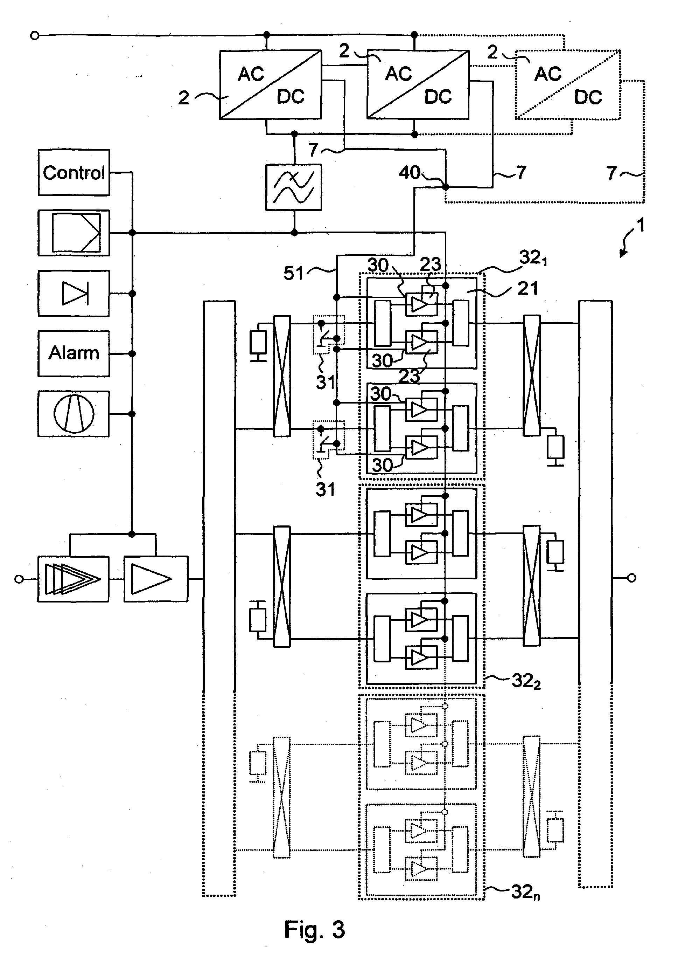

Fig. 3 stellt ein weiteres erfindungsgemäßes Ausführungsbeispiel dar, welches im Wesentlichen eine Erweiterung des Schaltplans aus Fig. 2 ist. Diesbezüglich wird auf die Beschreibung von Fig. 2 verwiesen. Im Gegensatz zu Fig. 2 versorgen nun n Netzteile 2 n Endstufeneinheiten 32₁, 32₂, 32ₙ. An einem Knoten 40 sind sämtliche Statusleitungen 7 der n Netzteile 2 unmittelbar miteinander verbunden. Dadurch, dass die Statusleitungen 7 an einen offenen Kollektorausgang der Netzteile 2 angeschlossen sind, kann dieser Knoten 40 als eine Oder-Verknüpfung betrachtet werden. Dieser Knoten 40 ist einzig mit den Schaltelementen 30 und den Schalteinheiten 31 der Endstufeneinheit 32₁ verbunden. Unabhängig davon, welches Netzteil 2 im Folgenden ausfällt, werden immer die Endstufenteile 21 der Endstufeneinheit 32₁ aktiv abgeschaltet, bzw. es wird bei einem Ausfall zumindest eines der n Netzteile 2 die Vorspannung der Leistungstransistoren des Endstufenteils 21, bzw. der Endstufeneinheit 32₁ abgeschaltet, welches ein Schaltelement 30 und/oder eine Schalteinheit 31 aufweist, denen das gemeinsame Fehlersignal zugeführt ist.

Entsprechend der Darstellung aus Fig. 2 liegen in Fig. 3 nun deutlich mehr Koppler vor. Aus Gründen der Übersichtlichkeit sind nur die 90°-Hybridkoppler dargestellt, die unmittelbar mit einem Endstufenteil 21, bzw. einer Endstufeneinheit 32₁ bis 32ₙ verbunden sind. Der Aufbau und die Verschaltung der 90°-Hybridkoppler erfolgt allerdings analog zu Fig. 2. Besonders vorteilhaft an diesem weiteren erfindungsgemäßen Ausführungsbeispiel ist, dass der Verschaltungsaufwand reduziert wird, weil ein Betrieb gerade dann noch als sinnvoll zu erachten ist, wenn maximal ein Netzteil 2 ausfällt oder die Netzteile 2 eine so hohe Zuverlässigkeit aufweisen, dass es unwahrscheinlich ist, dass zwei Netzteile 2 gleichzeitig ausfallen.

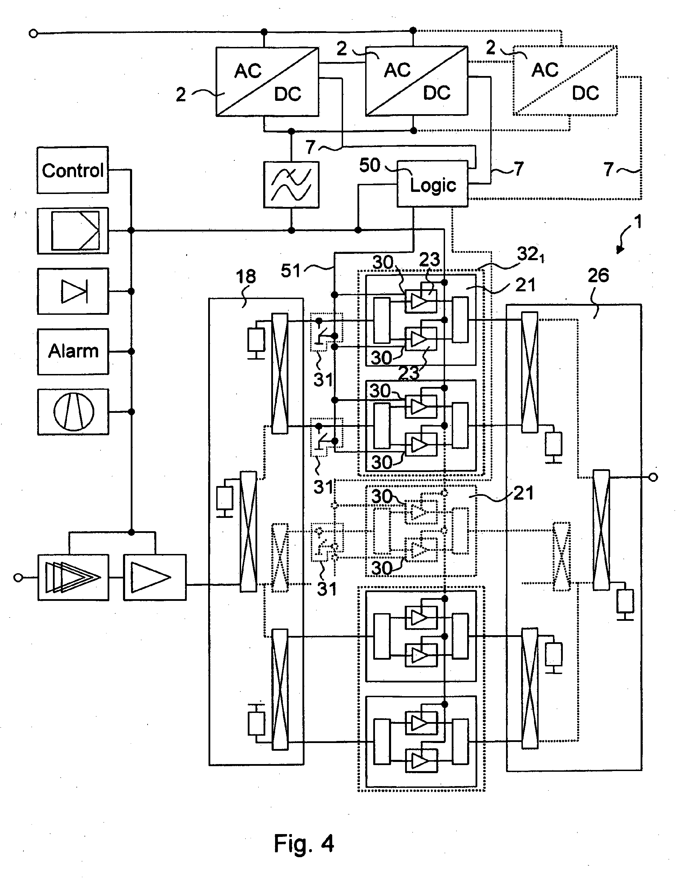

Fig. 4 zeigt einen Schaltplan eines weiteren erfindungsgemäßen Ausführungsbeispiels der Schaltungsanordnung zur redundanten Stromversorgung für einen Leistungsverstärker 1. Der Aufbau und die Funktionsweise entsprechen im Wesentlichen denen aus Fig. 1. Im Unterschied dazu, zeigt dieses erfindungsgemäße Ausführungsbeispiel eine Schaltungsanordnung, um n Netzteile 2 in einen Leistungsverstärker 1 integrieren zu können, wobei die Anzahl der Schaltelemente 30 und der Schalteinheiten 31 und damit der Herstellungsaufwand möglichst klein gehalten wird.

Sämtliche Netzteile sind an ihren lastseitigen Anschlüssen zusammengeschaltet. Die einzelnen Statusleitungen 7 der verschiedenen Netzteile 2, sind in diesem Ausführungsbeispiel nicht direkt mit einem oder mehreren Schaltelementen 30 oder Schalteinheiten 31 oder miteinander verbunden. Alle Statusleitungen 7 von diesen n Netzteilen 2 sind mit je einem Eingang einer Logikeinheit 50 verbunden, wobei bis zu n-1 Ausgangsleitungen der Logikeinheit 50 mit den Schaltelementen 30 und Schalteinheiten 31 von bis zu n-1 Endstufeneinheiten 32 verbunden sind und eine Endstufeneinheit 32 zwei Endstufenteile 21 aufweist. Von Vorteil ist dabei, dass nur so viele Endstufenteile 21 mit Schaltelementen 30 und optional Schalteinheiten 31 ausgestattet werden müssen, wie Netzteile 2 ausfallen dürfen, so dass gerade noch ein sinnvoller Betrieb möglich ist.

Die Logikeinheit 50 erfasst über das Fehlersignal der Statusleitung 7 der Netzteile 2 die Anzahl der ausgefallenen Netzteile 2 und schaltet die notwendige Anzahl an Endstufenteilen 21 ab. Über die Schaltelemente 30 kann die Vorspannung der Leistungstransistoren der Verstärkereinheiten 23 der Endstufenteile 21 abgeschaltet werden und optional kann über die Schalteinheiten 31 die Hochfrequenz-Eingangsleistung vom Eingang der Endstufenteile 21 gegen Masse geschaltet werden, damit die Leistung reflektiert und dem Lastausgleichswiderstand zugeführt wird. Sowohl die Schaltelemente 30, als auch die Schalteinheiten 31 werden zentral von der Logikeinheit 50 aus gesteuert. Die Anzahl der Schaltelemente 30 und der Schalteinheiten 31 kann dabei klein gehalten werden, wobei durch die Logikeinheit 50 jeder Ausfall eines Netzteils 2 erfasst wird und gleichzeitig eine Schalthandlung vorgenommen wird. Die Logikeinheit 50 ist dabei mit der gemeinsamen Versorgungsleitung verbunden, an der auch die zentralen Funktionseinheiten 9 angeschlossen sind.

Die Logikeinheit 50 selbst kann aus einzelnen Logikfunktionen, wie Und-Gattern, bzw. Oder-Gattern aufgebaut sein. Vorteilhafterweise wird die Logikeinheit 50 in einem Mikrokontroller oder in einem programmierbaren Logikbaustein (FPGA) realisiert. Diese Bausteine sind ohnehin für die Steuerung und Regelung vorhanden und bieten den Vorteil, dass Änderungen einfach durch eine Softwareänderung erfolgen können. Der Leistungsteiler 18 und der Leistungskoppler 26 enthalten die benötigte Anzahl an 90°-Hybridkopplern. Gepunktet angedeutet ist eine Verbindung zwischen einem ersten und einem zweiten, sowie einem dritten 90°-Hybridkoppler. Je nach Anzahl der Endstufenteile 21 können im Leistungsteiler 18 und Leistungskoppler 26 mehr als die gezeigten 90°-Hybridkoppler vorkommen.

Ebenfalls ist ein weiteres Endstufenteil 21 gepunktet angedeutet, um zu verdeutlichen, dass insgesamt n Endstufenteile 21 in einen Leistungsverstärker 1 eingebaut werden können. Dadurch wird gezeigt, wie mittels der erfindungsgemäßen Schaltanordnung der Leistungsverstärker 1 sehr einfach auf die Verwendung von mehreren Netzteilen 2, Endstufenteilen 21 und Kopplern skaliert werden kann. Das gepunktet angedeutete Endstufenteil 21 ist dabei mit Schaltelementen 30 und Schalteinheiten 31 versehen, die von einer zentralen Logikeinheit angesteuert werden. Weiterhin ist gepunktet eine Verbindung zu einem weiteren Endstufenteil 21 angedeutet, welches mit dem dargestellten Endstufenteil 21 eine Endstufeneinheit 32 bildet. Allerdings müssen nicht zwangsweise alle weiteren Endstufenteile 21 über Schaltelemente 30 und Schalteinheiten 31 verfügen.

Durch dieses weitere erfindungsgemäße Ausführungsbeispiel der Schaltungsanordnung zur redundanten Stromversorgung für einen Leistungsverstärker 1 kann mit einer kleinen Anzahl an Schaltelementen 30 und Schalteinheiten 31 ein hoch redundantes System zur Stromversorgung geschaffen werden, das für den Einsatz von bis zu n Netzteilen 2 gedacht ist.

Fig. 5 verdeutlicht anhand des exemplarisch herausgegriffenen 90°-Hybridkopplers 19₂ aus dem Leistungsteiler 18, weshalb es notwendig ist, dass beide Ausgänge des 90°-Hybridkopplers 192 durch die Schalteinheit 31 synchron gegen Masse geschaltet werden oder nicht. Der 90°-Hybridkoppler 19₂ weist neben einem Lastausgleichswiderstand 20₂ an seinen beiden Ausgängen jeweils eine Schalteinheit 31 auf, die den Ausgang auf Masse schalten kann und dadurch beide Ausgangssignale von den Ausgangsanschlüssen 61, 62 abkoppelt. An den Ausgangsanschlüssen 61, 62 sind die Endstufenteile 21₁, 21₂ angeschlossen. Am Eingangsanschluss 60 liegt ein Hochfrequenzsignal an. Im Normalbetrieb sind beide Endstufenteile 21₁, 21₂ in Betrieb und die Schalteinheiten 31 weisen die in Fig. 5 dargestellte Stellung auf. Ein Teil des Hochfrequenzsignals am Eingangsanschluss 60 wird über den Ausgangsanschluss 62 zum Endstufenteil 21₂ geleitet. Ein anderer Teil des Hochfrequenzsignals fließt durch den 90°-Hybridkoppler 19₂ und wird mit einer Phasenverschiebung von -90° über den Ausgangsanschluss 61 zum Endstufenteil 21₁ geleitet. Bei Anpassung wird keine Leistung in den Lastausgleichswiderstand 20₂ geleitet.

Für den Fall, dass die Endstufenteile 21₁, 21₂ abgeschaltet sind, sind die Schalteinheiten 31 geschlossen und verbinden die beiden Ausgänge des 90°-Hybridkopplers 19₂ mit Masse. Ein Teil des Signals, das am Eingang 60 anliegt, bewegt sich durch den 90°-Hybridkopplers 19₂ in Richtung des zweiten Ausgangsanschlusses 62. Die Phasenverschiebung von dem Signal an diesem Ausgang des 90°-Hybridkopplers 19₂ beträgt 0°. An dem Knoten 63, welcher über das Schaltelement 31 mit Masse verbunden ist, wird das Signal reflektiert, wobei die Phasenverschiebung weiterhin 0° aufweist. Ein Teil dieses reflektierten Signals bewegt sich vom zweiten Ausgang des 90°-Hybridkopplers 19₂ zurück zum Eingangsanschluss 60 des 90°-Hybridkopplers 19₂ und weist dort eine Phasenverschiebung von 0° auf. Ein Teil dieses reflektierten Signals bewegt sich vom zweiten Ausgang des 90°-Hybridkopplers 19₂ durch den 90°-Hybridkopplers 19₂ und erscheint mit einer Phasenverschiebung von -90° am Ausgang des 90°-Hybridkopplers 19₂, an welchem der Lastausgleichswiderstand 20₂ angeschlossen ist. Der Teil des Signals am Eingangsanschluss 60 des 90°-Hybridkopplers 19₂, welcher nicht am zweiten Ausgang erscheint, läuft durch den 90°-Hybridkopplers 19₂ und tritt an einem ersten Ausgang mit einer Phasenverschiebung von -90° auf. Der Knoten 64 ist mit Masse verbunden, so dass das Signal, welches am ersten Ausgang des 90°-Hybridkoppler 19₂ anliegt, reflektiert wird, wobei die Phasenverschiebung weiterhin -90° beträgt. Ein Teil des reflektierten Signals läuft durch den 90°-Hybridkoppler 19₂ und tritt mit einer Phasenverschiebung von -90° an der Stelle aus, an welcher der Lastausgleichswiderstand 20₂ angeschlossen ist.

Sowohl das Signal kommend vom zweiten Ausgang, als auch das Signal kommend vom ersten Ausgang, weist an dem Anschluss, an welchem der Lastausgleichswiderstand 20₂ angeschlossen ist, die gleiche Phasenverschiebung von -90° auf. Beide Signale werden summiert und die Energie wird von dem Lastausgleichswiderstand 20₂ aufgenommen. Ein weiterer Teil des Signals läuft vom ersten Ausgang durch den 90°-Hybridkoppler 19₂ zurück zum Eingang 60 des 90°-Hybridkopplers 19₂ und weist dort eine Phasenverschiebung von -180° auf, wohingegen das Signal kommend vom zweiten Eingang eine Phasenverschiebung von 0° aufweist. Beide Signale sind in ihrer Amplitude gleich groß, allerdings in ihrer Phase um 180° verschieden, so dass sie sich am Eingang 30 auslöschen. Das bedeutet, dass die gesamte reflektierte Leistung von beiden Ausgängen zum Lastausgleichswiderstand 20₂ läuft und dort vollständig absorbiert wird. Es wird also keine Leistung an den Eingang 60 reflektiert. Der Eingang 60 hat die gleich gute Anpassung wie vor dem Schalten. Dadurch wird das Auftreten von unerwünschten Frequenzgängen vermieden, die das Betriebsverhalten der noch in Betrieb befindlichen Endstufenverstärker beeinflussen würden. Dies gelingt allerdings nur, wenn beide Ausgänge eines 90°-Hybridkopplers 19₂ synchron zueinander geschalten werden, wie dies in allen dargestellten erfindungsgemäßen Ausführungsbeispielen der Fall ist.

Fig. 6 zeigt eine mögliche Ausführungsform des Schaltelements 30 der erfindungsgemäßen Schaltungsanordnung zur redundanten Stromversorgung für einen Leistungsverstärker 1, wie es verwendet wird, um die Vorspannung der Leistungstransistoren abzuschalten. Am Anschluss 71 wird eine Spannung angelegt, die über einen Vorwiderstand 72 dem Knoten 74 und damit dem Kollektor des Transistors 75 zugeführt wird. Die Basis des Transistors 75 ist mit der Signalleitung 7 verbunden, über die das Fehlersignal kommend von dem Netzteil 2 oder der Logikeinheit 50 dem Transistor 75 zugeführt wird. Der Emitter ist mit Masse verbunden. Am Knoten 74 ist die Basis eines weiteren Transistors 76 angeschlossen. Der Emitter dieses weiteren Transistors 76 ist wiederum mit Masse verbunden. Der Kollektor dieses Transistors 76 ist über eine Induktivität 77 mit der Basis 81, bzw. dem Gate 81 des Leistungstransistors verbunden.

Über eine Induktivität 78 und einen Vorwiderstand 79 wird eine Gleichspannung, welche am Anschluss 80 angelegt wird, der Basis, bzw. dem Gate 81 des Leistungstransistors zugeführt. Die Induktivität 78 dient dazu, dass keine hochfrequenten Signale in die Gleichspannungsversorgung einkoppeln. Im Normalbetrieb leitet der Transistor 75, wodurch der Transistor 76 gesperrt ist. Im Fehlerfall ist der Transistor 75 gesperrt, worauf der Transistor 76 zu leiten beginnt. Der Gleichspannungsanteil, welcher der Basis, bzw. dem Gate 81 des Leistungstransistors über den Vorwiderstand 79 und die Induktivität 78 zugeführt wird, wird über die Induktivität 77 und den Transistor 76 wieder gegen Masse abgeleitet. Bei Verwendung der Logikeinheit 50, kann das Ausgangssignal gleich invertiert werden, so dass auf den Transistor 75 verzichtet werden kann. Neben Transistoren können auch andere Bauelemente auf Halbleiterbasis eingesetzt werden. Auch mechanische Schalter wie Relais können für das Schaltelement 30 verwendet werden. Dadurch, dass nur Signalströme und somit keine hohen Leistungen geschaltet werden, kann auf die kompakte und kostengünstige Bauweise in SMD-Technik zurückgegriffen werden.

Fig. 7 zeigt eine mögliche Ausführungsform der Schalteinheit 31 der erfindungsgemäßen Schaltungsanordnung zur redundanten Stromversorgung für einen Leistungsverstärker 1, wie sie verwendet wird, um die Hochfrequenz-Eingangsleistung vom Endstufenteil 21 abzukoppeln. Der Eingangsanschluss 63, 64 entspricht dem Knoten 63 oder dem Knoten 64 aus Fig. 5. Dieser wird über den Koppelkondensator 95 mit dem Knoten 98 und damit mit dem Ausgangsanschluss 61, 62, welcher ebenfalls in Fig. 5 dargestellt ist, verbunden. An den Knoten 98 wird die Kathode einer PIN-Diode 96 (engl. positive intrinsic negative diode) angeschlossen. Die Anode der PIN-Diode 96 wird zum einen über einen Kondensator 97 mit Masse verbunden und zum anderen über die Induktivität 99 mit dem Eingangsanschluss 91 verbunden.

Der Knoten 98 wird zusätzlich über die Induktivität 94 zum einen mit dem Kollektor eines Transistors 93 verbunden und zum anderen mit dem Vorwiderstand 92. Der Vorwiderstand 92 ist mit seinem zweiten Anschluss mit dem Eingangsanschluss 90 verbunden. Der Emitter des Transistors 93 ist mit Masse verbunden. An die Basis des Transistors 93 ist der Kollektor eines weiteren Transistors 100 angeschlossen. An den Kollektor des Transistors 100 ist über einen Vorwiderstand 101 eine Gleichspannung angeschlossen. Der Emitter des Transistors 100 ist mit Masse verbunden und an der Basis des Transistors 100 liegt das Fehlersignal, kommend über die Statusleitung 7, an. An den Eingangsanschluss 90 muss eine Gleichspannung angelegt werden, die größer ist als die Gleichspannung, welche an den Eingangsanschluss 91 angelegt wird.

Im Normalbetrieb leitet der Transistor 100 und der Transistor 93 sperrt. Das Potential an der Kathode der Diode 96 ist höher als an der Anode der Diode 96. Die Diode 96 ist in diesem Zustand nicht leitend. Ein Hochfrequenz-Eingangssignal, welches an den Eingangsanschluss 63, 64 angelegt wird, kann am Ausgangsanschluss 61, 62 abgegriffen werden.

Im Fehlerfall sperrt der Transistor 100, worauf der Transistor 93 zu leiten beginnt. Das Potential an der Kathode der Diode 96 wird über die Induktivität 94 und den Transistor 93 auf Masse gezogen. Die Diode 96 beginnt zu leiten, weil das Potential an der Anode unverändert ist. Die Hochfrequenz-Eingangsleistung wird über den Koppelkondensator 95 und den Kondensator 97 gegen Masse geleitet, wodurch für die Hochfrequenz eine Totalreflexion am Knoten 61, 64 entsteht. Das bedeutet, dass das Signal, welches am Knoten 63, 64 eingespeist wird, vollständig reflektiert wird. Die Induktivitäten 94 und 99 verhindern, dass ein Teil der Hochfrequenzeingangsleistung in den Gleichstromversorgungskreis einkoppelt.

Die Erfindung ist nicht auf die dargestellten Ausführungsbeispiele beschränkt. Alle beschriebenen und/oder gezeichneten Elemente sind im Rahmen der Erfindung beliebig miteinander kombinierbar. Wird das Fehlersignal unter Verwendung der Logikeinheit 50 invertiert, dann kann z.B. auf den Transistor 100 verzichtet werden. Statt der gezeigten PIN-Diodenschaltung kann die Schaltung auch mit einem Relais aufgebaut werden.

## Patentansprüche

1. Schaltungsanordnung zur redundanten Stromversorgung für einen Leistungsverstärker (1), wobei der Leistungsverstärker (1) mehrere Endstufenteile (21) und mehrere Netzteile (2) aufweist und
wobei die Netzteile (2) an ihren lastseitigen Anschlüssen zusammengeschaltet sind und die Endstufenteile (21) mit Energie versorgen,
**dadurch gekennzeichnet,**
**dass** bei einem Ausfall von zumindest einem Netzteil (2) zumindest ein Endstufenteil (21) aktiv abgeschaltet wird.

2. Schaltungsanordnung nach Anspruch 1,
**dadurch gekennzeichnet,**
**dass** je zwei Endstufenteile (21) über einen 90°-Hybridkoppler (19) angesteuert werden und eine Endstufeneinheit (32₁, 32₂, 32ₙ) bilden.

3. Schaltungsanordnung nach Anspruch 1 oder 2,
**dadurch gekennzeichnet,**
**dass** jedes Netzteil (2) bei einem Ausfall über eine Statusleitung (7) ein Fehlersignal ausgibt und die Abschaltung des zumindest einen Endstufenteils (21) in Abhängigkeit des Fehlersignals erfolgt.

4. Schaltungsanordnung nach Anspruch 3,
**dadurch gekennzeichnet,**
**dass** die Statusleitung (7) von jedem Netzteil (2) miteinander so verbunden ist, dass ein gemeinsames Fehlersignal ausgegeben wird.

5. Schaltungsanordnung nach Anspruch 3,
**dadurch gekennzeichnet,**
**dass** die Statusleitungen (7) von n Netzteilen (2) je mit einem Eingang einer Logikeinheit (50) verbunden sind und dass n-1 Ausgangsleitungen der Logikeinheit (50) jeweils mit zumindest einem Endstufenteil (21) verbunden sind.

6. Schaltungsanordnung nach einem der Ansprüche 3 bis 5,
**dadurch gekennzeichnet,**
**dass** bei einem Ausfall zumindest eines Netzteils (2) das Endstufenteil (21) abgeschaltet wird, welchem das Fehlersignal dieses Netzteils (2) zugeführt ist, indem eine Vorspannung der Leistungstransistoren des Endstufenteils (21) mit einem Schaltelement (30) gegen Masse geschaltet ist.

7. Schaltungsanordnung nach dem Anspruch 6,
**dadurch gekennzeichnet,**
**dass** das Endstufenteil (21) durch eine Schalteinheit (31) von einer Hochfrequenz-Steuerleistung abgekoppelt wird und der Schalteinheit (31) das Fehlersignal dieses Netzteils (2) zugeführt ist.

8. Schaltungsanordnung nach Anspruch 4,
**dadurch gekennzeichnet,**
**dass** bei einem Ausfall zumindest eines Netzteils (2) die Vorspannung der Leistungstransistoren des Endstufenteils (21) abgeschaltet wird, welches ein Schaltelement (30) aufweist, dem das gemeinsame Fehlersignal zugeführt ist.

9. Schaltungsanordnung nach dem Anspruch 8,
**dadurch gekennzeichnet,**
**dass** das Endstufenteil (21), das über eine Schalteinheit (31) verfügt, über diese von einer Hochfrequenz-Steuerleitung abgekoppelt wird und der Schalteinheit (31) das gemeinsame Fehlersignal zugeführt ist.

10. Schaltungsanordnung nach Anspruch 5,
**dadurch gekennzeichnet,**
**dass** bei einem Ausfall von n-1 Netzteilen (2) über je ein Schaltelement (30) eine Vorspannung der Leistungstransistoren von bis zu n-1 Endstufenteilen (21) abgeschaltet wird und jedes Schaltelement (30) mit einem Ausgang der Logikeinheit (50) verbunden ist.

11. Schaltungsanordnung nach Anspruch 10,
**dadurch gekennzeichnet,**
**dass** zusätzlich bis zu n-1 Endstufenteile (21) durch je eine Schalteinheit (31) von einer Hochfrequenz-Steuerleitung abgekoppelt werden und diese Schalteinheit (31) mit einer Ausgangsleitung der Logikeinheit (50) verbunden ist.

12. Schaltungsanordnung nach Anspruch 7 oder 9 oder 11,
**dadurch gekennzeichnet,**
**dass** die Schalteinheit (31) eine PIN-Diode (96) aufweist, über die die Hochfrequenz-Steuerleistung nach Masse geschaltet wird.

13. Schaltungsanordnung nach Anspruch 2,
**dadurch gekennzeichnet,**
**dass** der 90°-Hybridkoppler (19,27) einen Lastausgleichwiderstand (20,28) aufweist, in welchem die reflektierte Leistung absorbiert wird.

14. Schaltungsanordnung nach einem der Ansprüche 1 bis 13,
**dadurch gekennzeichnet.**
**dass** die Netzteile (2) an ihren lastseitigen Anschlüssen an zumindest ein gemeinsames Filter (6) angeschlossen sind, um damit eine Beeinflussung der Netzteile (2) durch eine von den Endstufenteilen (21) erzeugte Hochfrequenzenergie zu vermeiden.

15. Schaltungsanordnung nach einem der Ansprüche 1 bis 14,
**dadurch gekennzeichnet,**
**dass** eine an die Netzteile (2) eine angeschlossene Last der Endstufenteile (21) derart aufgeteilt ist, dass jedes Netzteil (2) im fehlerfreien Betrieb die gleiche Leistung bereit stellt.

16. Schaltungsanordnung nach einem der Ansprüche 1 bis 15,
**dadurch gekennzeichnet,**
**dass** der Leistungsverstärker (1) Funktionseinheiten (9) aufweist, die zum Betrieb des Leistungsverstärkers (1) notwendig sind und dass diese Funktionseinheiten (9) über eine gemeinsame Stromversorgungsleitung mit allen Netzteilen (2) verbunden sind.

17. Schaltungsanordnung nach Anspruch 16,
**dadurch gekennzeichnet,**
**dass** die Funktionseinheiten (9) einen Vorverstärker (15), einen Treiberverstärker (16), eine Steuerung (10), eine Leistungsregelung (11) mit Hochfrequenz-Detektor (12), eine Fehlerüberwachung (13) und zumindest einen Lüfter (14) umfassen.

## Claims

1. Circuit arrangement for the redundant current supply of a power amplifier (1), wherein the power amplifier (1) exhibits a plurality of output stage parts (21) and a plurality of power supply units (2) and wherein the power supply units (2) are connected together at their load-side connections and supply the output stage parts (21) with energy,
**characterised in that** in the event of a failure of at least one power supply unit (2) at least one output stage part (21) is actively switched off.

2. Circuit arrangement according to claim 1,
**characterised in that** the output stage parts (21) are actuated in pairs through a 90° hybrid coupler (19) and form an output stage unit (32₁, 32₂, 32ₙ).

3. Circuit arrangement according to claim 1 or 2,
**characterised in that** in the event of failure each power supply unit (2) emits a fault signal through a status line (7) and the at least one output stage part (21) is switched off depending on the fault signal.

4. Circuit arrangement according to claim 3,
**characterised in that** the status line (7) from each power supply unit (2) is connected to the others so that a common fault signal is emitted.

5. Circuit arrangement according to claim 3,
**characterised in that** the status lines (7) from n power supply units (2) are each connected with an input of a logic unit (50) and **in that** n-1 output lines of the logic unit (50) are in each case connected with at least one output stage part (21).

6. Circuit arrangement according to one of claims 3 to 5,
**characterised in that** in the event of a failure of at least one power supply unit (2) the output stage part (21) to which the fault signal of this power supply unit (2) is sent is switched off **in that** a bias voltage of the power transistors of the output stage part (21) is switched to ground with a switching element (30).

7. Circuit arrangement according to claim 6,
**characterised in that** the output stage part (21) is uncoupled from a high-frequency control line by a switching unit (31) and the fault signal of this power supply unit (2) is fed to the switching unit (31).

8. Circuit arrangement according to claim 4,
**characterised in that** in the event of failure of at least one power supply unit (2) the bias voltage of the power transistors of the output stage part (21) exhibiting a switching element (30) to which the common fault signal is fed is switched off.

9. Circuit arrangement according to claim 8,
**characterised in that** the output stage part (21) having a switching unit (31) is uncoupled from a high-frequency control line by this switching unit and the common fault signal is fed to the switching unit (31).

10. Circuit arrangement according to claim 5,
**characterised in that** in the event of failure of n-1 power supply units (2) a bias voltage of the power transistors of up to n-1 output stage parts (21) is switched off by means of a switching element (30) in each case and each switching element (30) is connected with an output of the logic unit (50).

11. Circuit arrangement according to claim 10,
**characterised in that** in addition up to n-1 output stage parts (21) are uncoupled from a high-frequency control line by a switching unit (31) in each case and this switching unit (31) is connected with an output line of the logic unit (50).

12. Circuit arrangement according to claim 7 or 9 or 11,
**characterised in that** the switching unit (31) exhibits a PIN diode (96) through which the high-frequency control line is switched to ground.

13. Circuit arrangement according to claim 2,
**characterised in that** the 90° hybrid coupler (19, 27) exhibits a load equalising resistance (20, 28) in which the reflected power is absorbed.

14. Circuit arrangement according to one of claims 1 to 13,
**characterised in that** the power supply units (2) are connected at their load-side connections to at least one common filter (6) in order to avoid high-frequency energy generated by the output stage parts (21) affecting the power supply units (2).

15. Circuit arrangement according to one of claims 1 to 14,
**characterised in that** a load of the output stage parts (21) connected to the power supply units (2) is divided such that each power supply unit (2) provides the same power in fault-free operation.

16. Circuit arrangement according to one of claims 1 to 15,
**characterised in that** the power amplifier (1) exhibits function units (9) which are necessary for the operation of the power amplifier (1) and **in that** these function units (9) are connected with all the power supply units (2) through a common current supply line.

17. Circuit arrangement according to claim 16,
**characterised in that** the function units (9) comprise a pre-amplifier (15), a driver amplifier (16), a control unit (10), a power regulator (11) with a high-frequency detector (12), a fault monitor (13) and at least one fan (14).

## Revendications

1. Dispositif de circuit en vue de l'alimentation électrique redondante pour un amplificateur de puissance (1), dans lequel l'amplificateur de puissance (1) présente plusieurs parties amplificateur (21) et plusieurs parties bloc secteur (2) et
dans lequel les parties bloc secteur (2) sont reliées à leurs raccords côté charge et les parties amplificateur (21) délivrent de l'énergie,
**caractérisé en ce que**
en cas de panne d'au moins une partie bloc secteur (2), au moins une partie amplificateur (21) est activement coupée.

2. Dispositif de circuit selon la revendication 1, **caractérisé en ce que**
deux parties amplificateur (21) sont commandées par l'intermédiaire d'un coupleur hybride-90° (19) et forment une unité d'amplificateur (32₁, 32₂, 32ₙ).

3. Dispositif de circuit selon la revendication 1 ou 2, **caractérisé en ce que**
chaque partie bloc secteur (2) délivre un signal d'erreur par l'intermédiaire d'une ligne d'état (7) en cas de panne et il s'ensuit la coupure de la au moins une partie amplificateur (21) selon le signal d'erreur.

4. Dispositif de circuit selon la revendication 3, **caractérisé en ce que**
la ligne d'état (7) est reliée conjointement à chaque partie bloc secteur (2) de sorte qu'un signal d'erreur conjoint est délivré.

5. Dispositif de circuit selon la revendication 3, **caractérisé en ce que**
les lignes d'état (7) des n parties bloc secteur (2) sont reliées à une entrée d'une unité logique (50) et
**en ce que** n-1 lignes de sortie de l'unité logique (50) sont reliées respectivement à au moins une partie amplificateur (21).

6. Dispositif de circuit selon l'une des revendications 3 à 5, **caractérisé en ce que**
en cas de panne d'au moins une partie bloc secteur (2), une partie amplificateur (21) est coupée, à laquelle le signal d'erreur de cette partie bloc secteur (2) est délivré, tandis qu'une tension initiale des transistors de capacité de la partie amplificateur (21) est reliée à la masse par un élément de circuit (30).

7. Dispositif de circuit selon la revendication 6, **caractérisé en ce que**
la partie amplificateur (21) est découplée par l'intermédiaire d'une unité de circuit (31) d'une puissance de commande à haute fréquence et le signal d'erreur de cette partie bloc secteur (2) est délivré à l'unité de circuit (31).

8. Dispositif de circuit selon la revendication 4, **caractérisé en ce que**
en cas de panne d'au moins une partie bloc secteur (2) la tension initiale des transistors de capacité de la partie amplificateur (21) est couplée, partie amplificateur qui présente un élément de circuit (30), à laquelle le signal d'erreur commun est délivré.

9. Dispositif de circuit selon la revendication 8, **caractérisé en ce que**
la partie amplificateur (21), qui dispose d'une unité de circuit (31), est découplée par l'intermédiaire de celle-ci d'une ligne de commande à haute fréquence et le signal d'erreur commun est délivré à l'unité de circuit (31).

10. Dispositif de circuit selon la revendication 5, **caractérisé en ce que**
en cas de panne des n-1 parties bloc secteur (2) une tension initiale des transistors de capacité jusqu'à n-1 parties amplificateur (21) est coupée par l'intermédiaire d'un élément de circuit (30) et chaque élément de circuit (30) est relié à une sortie de l'unité logique (50).

11. Dispositif de circuit selon la revendication 10, **caractérisé en ce que**
en plus n-1 parties amplificateur (21) sont découplées par l'intermédiaire d'une unité de circuit (31) d'une ligne de commande à haute fréquence et cette unité de circuit (31) est reliée à une ligne de sortie de l'unité logique (50).

12. Dispositif de circuit selon la revendication 7 ou 9 ou 11, **caractérisé en ce que**
l'unité de circuit (31) présente une diode PIN (96), par l'intermédiaire de laquelle la puissance de commande haute fréquence est reliée à la masse.

13. Dispositif de circuit selon la revendication 2, **caractérisé en ce que**
le coupleur hybride-90° (19, 27) présente une résistance de compensation de charge (20, 28), dans laquelle la capacité réfléchie est absorbée.

14. Dispositif de circuit selon l'une des revendications 1 à 13, **caractérisé en ce que**
les parties bloc secteur (2) sont reliées à leurs raccords côté charge à au moins un filtre commun (6), afin d'éviter une influence des parties bloc secteur (2) provoquée par une énergie haute fréquence produite par les parties amplificateur (21).

15. Dispositif de circuit selon l'une des revendications 1 à 14, **caractérisé en ce que**
une charge connectée des parties amplificateur (21) est répartie sur les parties bloc secteur (2), de sorte que chaque partie bloc secteur (2) délivre la même capacité en cas de fonctionnement correct.

16. Dispositif de circuit selon l'une des revendications 1 à 15, **caractérisé en ce que**
l'amplificateur de puissance (1) présente des unités fonctionnelles (9), qui sont nécessaires pour le fonctionnement de l'amplificateur de puissance (1) et **en ce que** ces unités fonctionnelles sont reliées par l'intermédiaire d'une ligne d'alimentation de courant commune à toutes les parties bloc secteur (2).

17. Dispositif de circuit selon la revendication 16, **caractérisé en ce que**
les unités fonctionnelles (9) comprennent un préamplificateur (15), un amplificateur de commande (16), une commande (10), un dispositif de réglage de puissance (11) avec un détecteur haute fréquence (12), un dispositif de surveillance d'erreur (13) et au moins un ventilateur (14).
